(19) Europäisches Patentamt / European Patent Office / Office européen des brevets

(11) **EP 3 226 668 B1**

(12) **EUROPEAN PATENT SPECIFICATION**

(45) Date of publication and mention
of the grant of the patent:
**05.05.2021 Bulletin 2021/18**

(51) Int Cl.:
***H05K 9/00*** *(2006.01)*

(21) Application number: **16200503.7**

(22) Date of filing: **24.11.2016**

(54) **NEAR-FIELD ELECTROMAGNETIC WAVE ABSORBING FILM**

ABSORBIERENDE FOLIE FÜR ELEKTROMAGNETISCHE NAHFELDWELLEN

FILM D'ABSORPTION D'ONDE ÉLECTROMAGNÉTIQUE À CHAMP PROCHE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **01.04.2016 JP 2016074369**

(43) Date of publication of application:
**04.10.2017 Bulletin 2017/40**

(73) Proprietor: **Kagawa, Seiji
Saitama 343-0807 (JP)**

(72) Inventor: **Kagawa, Seiji
Saitama 343-0807 (JP)**

(74) Representative: **SSM Sandmair
Patentanwälte Rechtsanwalt
Partnerschaft mbB
Joseph-Wild-Straße 20
81829 München (DE)**

(56) References cited:
**EP-A1- 1 993 338        WO-A1-2014/148589
WO-A2-2011/017037        US-A1- 2014 224 411**

EP 3 226 668 B1

**Description**

FIELD OF THE INVENTION

The present invention relates to a near-field electromagnetic wave absorbing film having excellent electromagnetic wave absorbability and transmission viewability.

BACKGROUND OF THE INVENTION

Electromagnetic wave absorbing sheets for preventing the leak and intrusion of electromagnetic waves are used in communications equipment such as mobile phones, smartphones, wireless LANs, etc., and electronic appliances such as computers, etc. Electromagnetic wave absorbing sheets widely used at present are formed by metal sheets or nets, and electromagnetic wave absorbing sheets comprising vapour-deposited metal films formed on plastic sheets have recently been proposed. For example, JP 9-148782 A proposes an electromagnetic wave absorbing sheet comprising a plastic film, and first and second vapour-deposited aluminum films formed on both surfaces of the plastic film, the first vapour-deposited aluminum film being etched in a non-conductive linear pattern, and the second vapour-deposited aluminum film being etched in a conductive network-shaped pattern.

WO 2010/093027 discloses a composite film comprising a single-layer or multi-layer thin metal film formed on at least one surface of a plastic film, the thin metal film being provided with large numbers of substantially parallel, intermittent linear scratches with irregular widths and intervals in a plurality of directions, thereby having a reduced anisotropy of electromagnetic wave absorbability.

In the electromagnetic wave absorbing sheet of JP 9-148782 A and the composite film of WO 2010/093027 having a linear-scratched thin metal film, electromagnetic wave absorbability is obtained by a linear pattern or linear scratches. However, it is also desirable to efficiently obtain an electromagnetic wave absorbing film having excellent electromagnetic wave absorbability by forming laser-beam-bored holes in a pattern.

Furthermore, due to the demand for transparent electromagnetic wave absorbing films, electromagnetic wave absorbing films having thin ITO films or thin CNT films are proposed and used for ETCs, etc. However, electromagnetic wave absorbing films used for ETCs are far-field electromagnetic wave absorbing films, which are not used as near-field electromagnetic wave absorbing films because of difficulty in impedance control for near-field electromagnetic waves. One aim is therefore a near-field electromagnetic wave absorbing film comprising an opaque layer having electromagnetic wave absorbability, through which items can be viewed. This characteristic is called "transmission viewability."

EP 1993338 A1 discloses a process for preparing a light-transmissive, electromagnetic wave-shielding material, comprising: coating a transparent substrate with a pre-treatment agent for electroless plating comprising a noble metal compound and a mixture of a silane coupling agent and an azole compound or a reaction product thereof, to form a coated layer; drying the coated layer to provide a pre-treatment layer having a high light-transmissive property on the transparent substrate; forming a plating protective layer, consisting of at least one selected from the group consisting of acrylic resin, polyester resin, polyvinyl chloride resin and polystyrene resin, in a dot pattern on the pre-treatment layer; and subjecting the exposing part of the pre-treatment layer having no plating protective layer to electroless plating, to form a metal conductive layer in a mesh pattern.

WO 2014/148589 A1 discloses an electromagnetic wave-shielding plate having an intermediate layer and a conductive aluminum layer formed by sputtering or vacuum deposition on a glass substrate in this order, wherein the intermediate layer and the conductive aluminum layer are provided with openings by wet etching, and the intermediate layer is made of a mixture of at least one metal selected from the group consisting of chromium, molybdenum and tungsten, and at least one oxide selected from the group consisting of silicon oxides and aluminum oxides. When the intermediate layer and the conductive aluminum layer are in a lattice shape, the lattice may have a width of 5 to 50 $\mu$m and a pitch of 50 to 500 $\mu$m.

OBJECT OF THE INVENTION

Accordingly, an object of the present invention is to provide a near-field electromagnetic wave absorbing film having excellent electromagnetic wave absorbability and transmission viewability.

SUMMARY OF THE INVENTION

As a result of intensive research in view of the above object, the inventor has found that with (a) laser-beam-bored holes of 200 $\mu$m or less in diameter formed with intervals of 50 $\mu$m or less, and (b) pluralities of openings as large as giving transmission viewability formed partially, on an entire surface of a thin metal film on a plastic film, a near-field electromagnetic wave absorbing film having excellent electromagnetic wave absorbability and transmission viewability can be obtained. The present invention has been completed based on such findings.

Thus, the near-field electromagnetic wave absorbing film of the present invention comprises a plastic film and a single-layer or multi-layer thin metal film formed on at least one surface of the plastic film; wherein the thin metal film has laser-beam-bored holes of 200 μm or less in diameter with intervals of 50 μm or less, and pluralities of openings as large as 2 to 20 mm in diameter or width, on the entire surface; and the area ratio of said openings is 15 to 60 %, to give transmission viewability.

The diameters of the laser-beam-bored holes are preferably 100 μm or less, more preferably 20 to 100 μm.

The laser-beam-bored holes are preferably arranged with intervals of 20 μm or less.

The openings formed in the thin metal film are preferably arranged in at least two directions.

The area ratio of the openings in the thin metal film is 15 to 60%.

The thickness of the thin metal film is preferably 10 to 300 nm.

The thin metal film is preferably at least one metal selected from the group consisting of aluminum, copper, silver, tin, nickel, cobalt, chromium and their alloys.

BRIEF DESCRIPTION OF THE DRAWINGS

Figure 1(a) is a partial, enlarged plan view showing an example of arrangements of fine laser-beam-bored holes for forming the near-field electromagnetic wave absorbing film of the present invention.

Figure 1(b) is a cross-sectional view taken along the line A-A in Figure 1.

Figure 1(c) is a partial, enlarged view of Figure 1(a).

Figure 2 is a partial, enlarged plan view showing another example of arrangements of fine laser-beam-bored holes for forming the near-field electromagnetic wave absorbing film of the present invention.

Figure 3 is a plan view showing an example of arrangements of openings for forming the near-field electromagnetic wave absorbing film of the present invention.

Figure 4 is a plan view showing another example of arrangements of openings for forming the near-field electromagnetic wave absorbing film of the present invention.

Figure 5 is a plan view showing yet another example of arrangements of openings for forming the near-field electromagnetic wave absorbing film of the present invention.

Figure 6 is a plan view showing yet another example of arrangements of openings for forming the near-field electromagnetic wave absorbing film of the present invention.

Figure 7 is a plan view showing yet another example of arrangements of openings for forming the near-field electromagnetic wave absorbing film of the present invention.

Figure 8 is a plan view showing yet another example of arrangements of openings for forming the near-field electromagnetic wave absorbing film of the present invention.

Figure 9 is a plan view showing yet another example of arrangements of openings for forming the near-field electromagnetic wave absorbing film of the present invention.

Figure 10(a) is a perspective view showing an apparatus for measuring the electrical resistance of a near-field electromagnetic wave absorbing film.

Figure 10(b) is a plan view showing the measurement of the electrical resistance of a near-field electromagnetic wave absorbing film by the apparatus of Figure 10(a).

Figure 10(c) is a cross-sectional view taken along the line B-B in Figure 10(b).

Figure 11(a) is a plan view showing a system for evaluating the electromagnetic wave absorbability of a near-field electromagnetic wave absorbing film.

Figure 11(b) is a partially cross-sectional front view showing a system for evaluating the electromagnetic wave absorbability of a near-field electromagnetic wave absorbing film.

Figure 12 is a photomicrograph showing the bored composite film of Reference Example 1.

Figure 13 is a photomicrograph showing the bored composite film of Comparative Example 1.

Figure 14 is a photomicrograph showing the bored composite film of Comparative Example 2.

Figure 15 is a graph showing the relationship between $S_{11}$ and the frequency of incident electromagnetic waves in the bored composite films of Reference Example 1 and Comparative Examples 1 and 2.

Figure 16 is a graph showing the relationship between the transmission attenuation power ratio Rtp and the frequency of incident electromagnetic waves in the bored composite films of Reference Example 1 and Comparative Examples 1 and 2.

Figure 17 is a graph showing $P_{loss}/P_{in}$ for the near-field electromagnetic wave absorbing film of Reference Example 1 at 0.1 to 6 GHz.

Figure 18 is a photomicrograph showing the bored composite film of Reference Example 2.

Figure 19 is a graph showing $P_{loss}/P_{in}$ for the bored composite film of Reference Example 2 at 0.1 to 6 GHz.

Figure 20 is a graph showing $S_{11}$, $S_{21}$ and Rtp for the near-field electromagnetic wave absorbing film of Example 1 at 0.1 to 6 GHz.

Figure 21 is a graph showing the $P_{loss}/P_{in}$ of the near-field electromagnetic wave absorbing film of Example 1 at 0.1 to 6 GHz.

Figure 22 is a graph showing the $S_{11}$, $S_{21}$ and Rtp of the near-field electromagnetic wave absorbing film of Example 2 at 0.1 to 6 GHz.

Figure 23 is a graph showing the $P_{loss}/P_{in}$ of the near-field electromagnetic wave absorbing film of Example 2 at 0.1 to 6 GHz.

Figure 24 is a graph showing the $S_{11}$, $S_{21}$ and Rtp of the near-field electromagnetic wave absorbing film of Example 3 at 0.1 to 6 GHz.

Figure 25 is a graph showing the $P_{loss}/P_{in}$ of the near-field electromagnetic wave absorbing film of Example 3 at 0.1 to 6 GHz.

Figure 26 is a graph showing the $S_{11}$, $S_{21}$ and Rtp of the near-field electromagnetic wave absorbing film of Example 4 at 0.1 to 6 GHz.

Figure 27 is a graph showing the $P_{loss}/P_{in}$ of the near-field electromagnetic wave absorbing film of Example 4 at 0.1 to 6 GHz.

Figure 28 is a graph showing the $S_{11}$, $S_{21}$ and Rtp of the near-field electromagnetic wave absorbing film of Example 5 at 0.1 to 6 GHz.

Figure 29 is a graph showing the $P_{loss}/P_{in}$ of the near-field electromagnetic wave absorbing film of Example 5 at 0.1 to 6 GHz.

## DESCRIPTION OF THE PREFERRED EMBODIMENTS

The embodiments of the present invention will now be explained by referring to the attached drawings, and it should be noted that any explanation concerning one embodiment is applicable to other embodiments unless otherwise mentioned. The following explanations are also not restrictive; rather, various modifications may be made within the scope of the present invention.

[1] Bored thin metal film

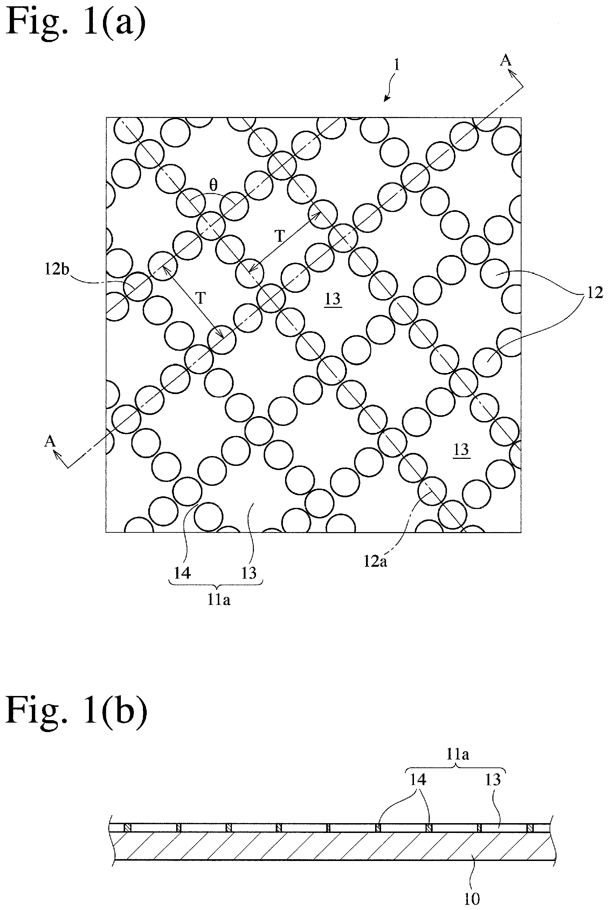

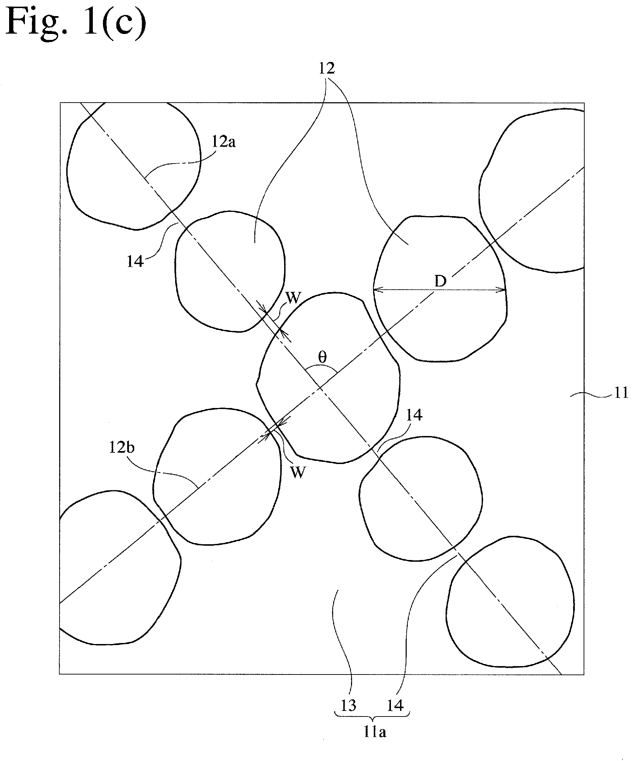

Figures 1(a) to 1(c) show an example of arrangements of fine laser-beam-bored holes for forming the near-field electromagnetic wave absorbing film of the present invention. A thin metal film provided with large numbers of fine laser-beam-bored holes is hereinafter referred to as the "bored thin metal film." This bored thin metal film 1 is obtained by forming holes 12 in two crossing lines by laser beams in the single-layer or multi-layer thin metal film 11 formed on a surface of the plastic film 10.

(1) Plastic film

Resins forming the plastic film 10 are not particularly restrictive as long as they have sufficient strength, flexibility and workability in addition to insulation, and they may be for instance polyesters (polyethylene terephthalate, etc.), polyarylene sulfides (polyphenylene sulfide, etc.), polyamides, polyimides, polyamide imides, polyether sulfone, polyether ether ketone, polycarbonates, acrylic resins, polystyrenes, polyolefins (polyethylene, polypropylene, etc.), etc. From the point of view of strength and cost, polyethylene terephthalate (PET) is preferable. The thickness of the plastic film 10 may be about 10 to 100 $\mu$m.

(2) Thin metal film

Metals forming the thin metal film 11 are not particularly restrictive as long as they have conductivity, and they are preferably aluminum, copper, silver, tin, nickel, cobalt, chromium and their alloys, particularly aluminum, copper, nickel and their alloys, from the point of view of corrosion resistance and cost. The thickness of the thin metal film is preferably 10 to 300 nm, more preferably 20 to 200 nm, and most preferably 30 to 150 nm. The thin metal film 11 can be formed by vapour deposition (physical vapour deposition such as vacuum vapour deposition, sputtering or ion plating, or chemical vapour deposition such as plasma CVD, thermal CVD or photo-CVD), plating, or foil bonding.

When the thin metal film 11 is a single layer, it is preferably made of aluminum or nickel, from the point of view of conductivity, corrosion resistance and cost. When the thin metal film 11 is a composite layer, one layer may be formed by a non-magnetic metal, and the other layer may be formed by a magnetic metal. The non-magnetic metal may be aluminum, copper, silver, tin or their alloys, and the magnetic metal may be nickel, cobalt, chromium or their alloys. The thickness of the non-magnetic metal layer and the thickness of the magnetic metal layer are not restrictive as long as their total thickness is within the above range.

(3) Laser-beam-bored holes

As shown in Figures 1(a) to 1(c), each laser-beam-bored hole 12 is a substantially circular hole formed by evaporating a metal by irradiating a laser beam onto the thin metal film 11, without opening the plastic film 10. The diameter D of each laser-beam-bored hole 12 is 200 $\mu$m or less. When the diameter D is more than 200 $\mu$m, the number of laser-beam-bored holes 12 formed in a unit area is too small, resulting in too large portions of the thin metal film 11 remaining between the laser-beam-bored holes 12, which act as a reflecting film, thus failing to obtain sufficient electromagnetic wave absorbability. The diameter D of each laser-beam-bored hole 12 is 200 $\mu$m or less, more preferably 20 to 100 $\mu$m.

In the depicted example, the laser-beam-bored holes 12 are arranged in two crossing lines in the thin metal film 11. The thin metal film 11 is partitioned into individual main remaining portions 13 by crossing lines 12a, 12b of laser-beam-bored holes. Because the laser-beam-bored holes 12 are arranged with at least partial intervals, interval portions of the thin metal film 11 remain as narrow bridge-like portions 14. Accordingly, thin metal film portions 11a remaining after forming the laser-beam-bored holes 12, which are called "remaining thin metal film portions," consist of the main remaining portions 13 and the narrow bridge-like portions 14.

The laser-beam-bored holes 12 are preferably arranged with intervals in both lines 12a, 12b. The intervals W between adjacent laser-beam-bored holes 12 (widths of the bridge-like portions 14) are 50 $\mu$m or less. When the intervals W are more than 50 $\mu$m, the bored thin metal film 1 does not have the desired electrical resistance. The intervals W between adjacent laser-beam-bored holes 12 (widths of the bridge-like portions 14) are preferably 20 $\mu$m or less, more preferably 1 to 15 $\mu$m. Accordingly, the maximum width Wmax of the bridge-like portions 14 is 50 $\mu$m, preferably 20 $\mu$m. The average width Wav of the bridge-like portions 14 is 3 to 30 $\mu$m, preferably 5 to 20 $\mu$m.

Though laser beam spots per se are circular, regions of the thin metal film 1 evaporated by laser beams are not completely circular but tend to have slightly irregular contours due to interference between adjacent laser-beam-bored holes 12. For example, when there is no space between adjacent laser-beam-bored holes 12, both laser-beam-bored holes 12, 12 are not in contact, but may have bridge-like portions 14 with small widths. This seems to be due to the fact that an evaporated metal is solidified between adjacent laser beam spots, resulting in narrow bridge-like portions 14. Thus, even with laser beam spots arranged with the same interval, the laser-beam-bored holes 12 actually formed by the evaporation of the thin metal film 11 do not have the same interval, but rather the bridge-like portions 14 have different widths W within a range of 50 $\mu$m or less. Accordingly, the near-field electromagnetic wave absorbing film of the present invention has excellent electromagnetic wave absorbability in a wide range of frequencies.

The lines 12a, 12b of laser-beam-bored holes cross at an angle $\theta$ of 45 to 90°, thereby providing high electromagnetic wave absorbability with low anisotropy. When the crossing angle $\theta$ is less than 45°, sufficient electromagnetic wave absorbability cannot be obtained. The crossing angle $\theta$ of 90° provides the maximum electromagnetic wave absorbability. The preferred crossing angle $\theta$ is 60 to 90°.

The size of the main remaining portions 13 largely depends on the centreline distance T between adjacent lines of laser-beam-bored holes 12a, 12b. Because the size of the main remaining portions 13 affects the electrical resistance (thus, electromagnetic wave absorbability) of the near-field electromagnetic wave absorbing film 20, the centreline distance T between adjacent lines 12a, 12b of laser-beam-bored holes should be set to have desired electrical resistance. Specifically, the centreline distance T between adjacent lines 12a, 12b of laser-beam-bored holes is preferably 100 to 400 $\mu$m, more preferably 150 to 300 $\mu$m.

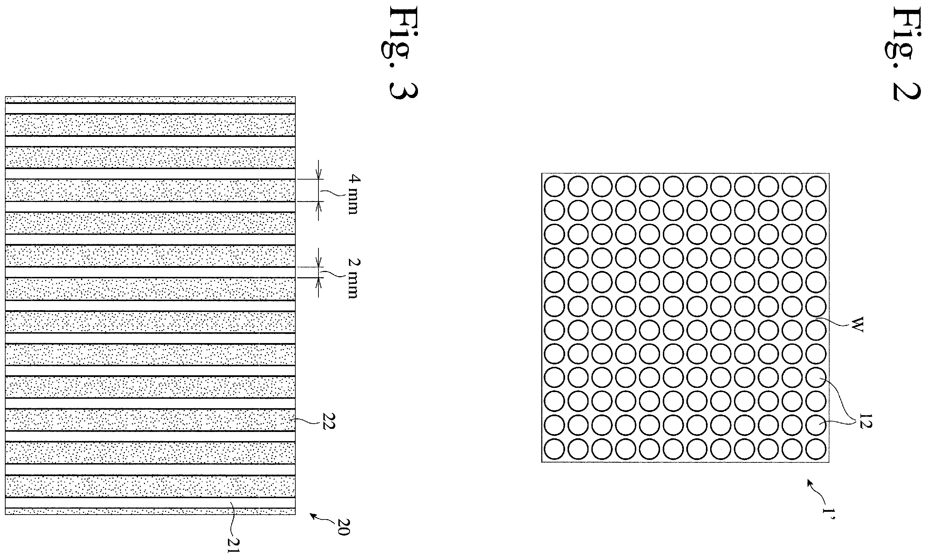

Figure 2 shows another example of arrangements of fine laser-beam-bored holes for forming the near-field electromagnetic wave absorbing film of the present invention. In this bored thin metal film 1', pluralities of laser-beam-bored holes 12 are arranged with substantially the same interval W in both vertical directions. As in the above example, the interval W is 50 $\mu$m or less, preferably 20 $\mu$m or less, and more preferably 1 to 15 $\mu$m.

(4) Openings

Pluralities of openings as large as giving transmission viewability are partially formed in the bored thin metal film, to produce a near-field electromagnetic wave absorbing film. The shapes and arrangements of the openings are not restrictive, as long as the necessary transmission viewability is obtained while securing sufficient electromagnetic wave absorbability. The sizes of the openings are also not restrictive, as long as the necessary transmission viewability is obtained while securing sufficient electromagnetic wave absorbability, though they preferably have diameters of several millimetres to several tens of millimetres, for example when they are circular as shown in Figure 2. In general, the openings are as large as 2 to 20 mm in diameter or width. Figures 3 to 9 show examples of the shapes, sizes and arrangements of the openings. Though the openings may be arranged in one direction, they are preferably arranged in at least two directions.

In the near-field electromagnetic wave absorbing film 20 shown in Figure 3, pluralities of parallel slit-like openings 21 are formed in the bored thin metal film 1. Thin metal film portions 22 which remain after the slit-like openings 21 are formed, and which may be called post-opening remaining portions, have a ribbon shape.

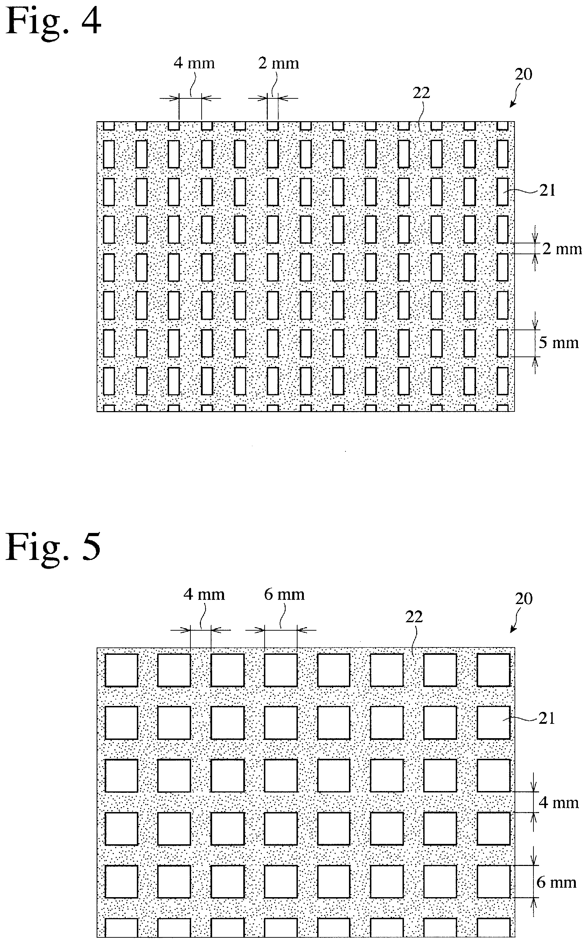

In the near-field electromagnetic wave absorbing film 20 shown in Figure 4, pluralities of rectangular openings 21 are formed in parallel longitudinally and transversely in the bored thin metal film 1. Thin metal film portions 22 which remain after the rectangular openings 21 are formed, and which may be called post-opening remaining portions, have a lattice shape.

In the near-field electromagnetic wave absorbing film 20 shown in Figure 5, pluralities of square openings 21 are formed in parallel longitudinally and transversely in the bored thin metal film 1. Thin metal film portions 22 which remain after the square openings 21 are formed, and which may be called post-opening remaining portions, have a lattice shape.

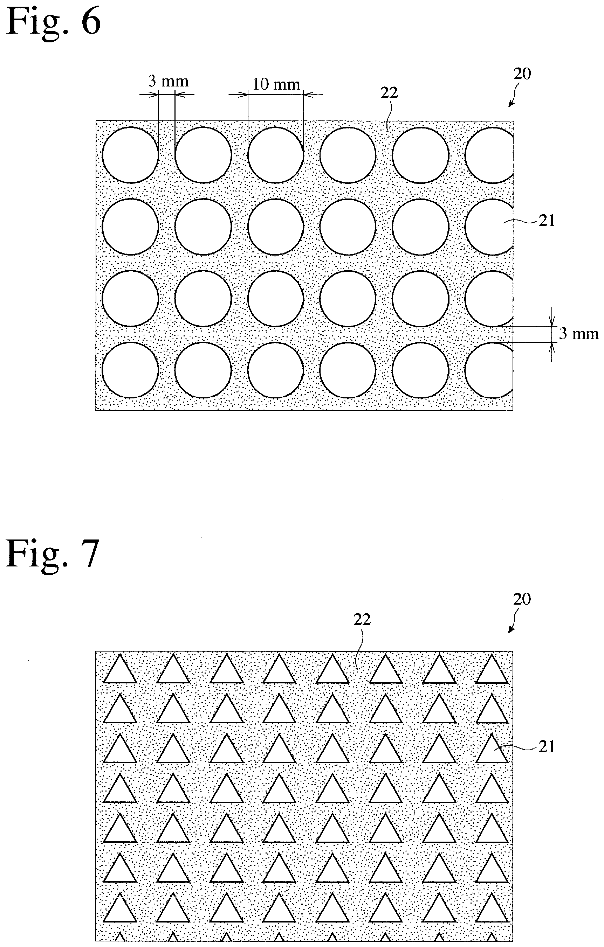

In the near-field electromagnetic wave absorbing film 20 shown in Figure 6, pluralities of circular openings 21 are formed in parallel longitudinally and transversely in the bored thin metal film 1. Thin metal film portions 22 which remain after the circular openings 21 are formed, and which may be called post-opening remaining portions, have a lattice shape.

In the near-field electromagnetic wave absorbing film 20 shown in Figure 7, pluralities of triangular openings 21 are formed in parallel longitudinally and transversely in the bored thin metal film 1. Thin metal film portions 22 which remain after the triangular openings 21 are formed, and which may be called post-opening remaining portions, have a deformed lattice shape.

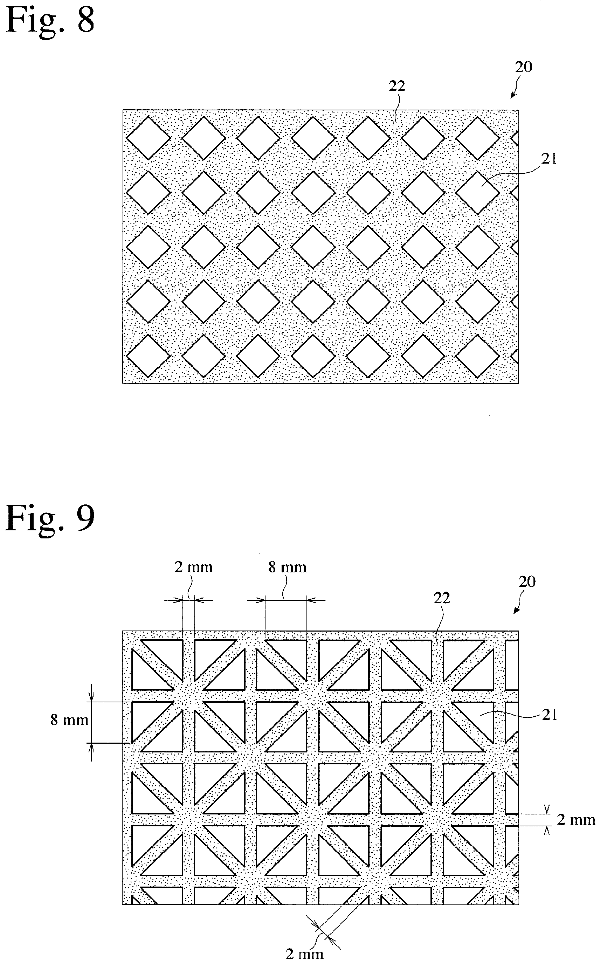

In the near-field electromagnetic wave absorbing film 20 shown in Figure 8, pluralities of rhombic openings 21 are formed in parallel longitudinally and transversely in the bored thin metal film 1. Thin metal film portions 22 which remain after the rhombic (inclined square) openings 21 are formed, and which may be called post-opening remaining portions, have a deformed lattice shape.

In the near-field electromagnetic wave absorbing film 20 shown in Figure 9, a plurality of pairs of triangular openings 21 are formed in parallel longitudinally and transversely in the bored thin metal film 1. Thin metal film portions 22 which remain after the pairs of triangular openings 21 are formed, and which may be called post-opening remaining portions, have a deformed lattice shape.

As shown in Figures 3 to 9, the post-opening remaining portions 22 should be connected in at least one direction and preferably in at least two directions. The area ratio of the openings 21 to the bored thin metal film 1 [100 × total area of openings 21 / (total area of openings 21 + total area of post-opening remaining portions 22)] is 15 to 60%, preferably 20 to 50%. When the area ratio of the openings 21 is less than 15%, sufficient transmission viewability cannot be obtained. On the other hand, when the area ratio of the openings 21 is more than 60%, sufficient electromagnetic wave absorbability cannot be secured.

(4) Electrical resistance

The electromagnetic wave absorbability of the near-field electromagnetic wave absorbing film 20 basically depends on the electromagnetic wave absorbability of the bored thin metal film 1. Intensive research has revealed that the electromagnetic wave absorbability of the bored thin metal film 1 depends on the size and electrical resistance of the bored thin metal film portions 11a remaining after the laser-beam-bored holes 12 are formed (i.e. remaining bored thin metal film portions 11a = bored main remaining portions 13 + bored bridge-like portions 14). The bored thin metal film 1 having an electrical resistance of 50 to 300 $\Omega/100 \, cm^2$ has excellent electromagnetic wave absorbability in a wide range of frequencies.

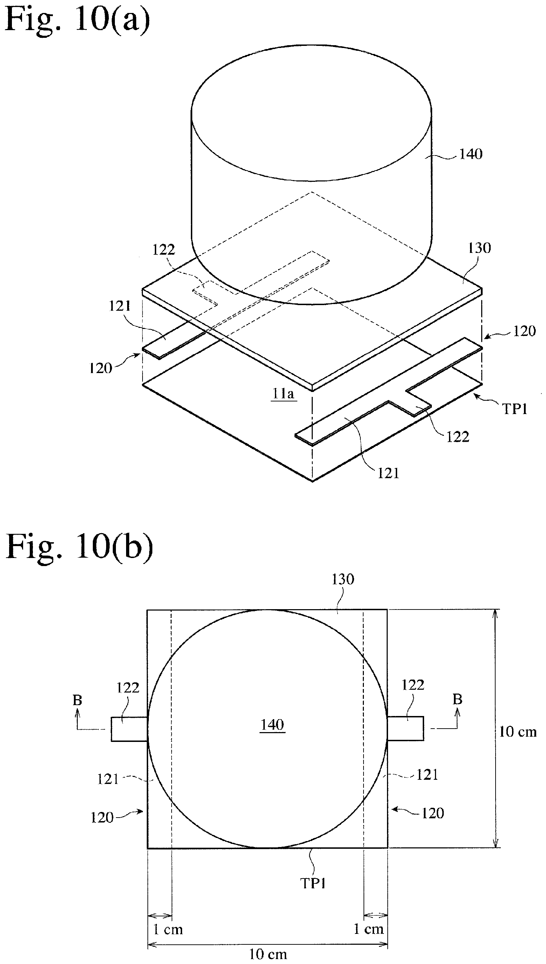

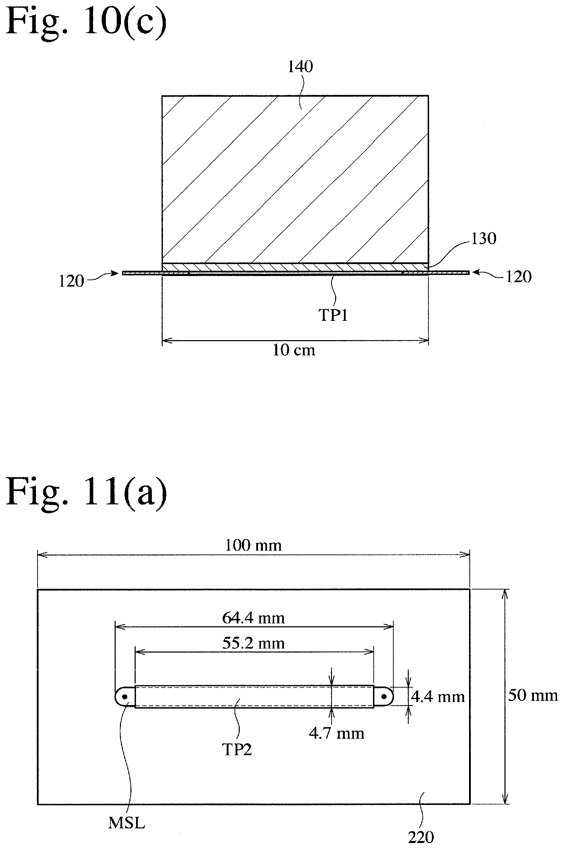

The electrical resistance of the bored thin metal film 1 is measured by a DC two-terminal method under pressure (simply called "under-pressure two-terminal method"), using an apparatus shown in Figures 10(a) to 10(c), to which a test piece TP1 of a composite film comprising a bored thin metal film 1 on a surface of a plastic film 10 is provided. Specifically, a square test piece TP1 of 10 cm × 10 cm is placed, with its bored thin metal film 1 on top, on a flat, hard insulation surface; and a pair of electrodes 120, 120 each comprising an electrode body portion 121 of 10 cm in length, 1 cm in width and 0.5 mm in thickness, and an electrode extension 122 of 1 cm in width and 0.5 mm in thickness extending from a centre side of the electrode body portion 121, are attached to opposing side portions of the square test piece TP1. A transparent acrylic plate 130 of 10 cm × 10 cm × 5 mm is placed on the test piece TP1 and both electrodes 120, 120, such that it completely covers them, and a cylindrical weight 140 (3.85 kg) of 10 cm in diameter is placed on the transparent acrylic plate 130, to measure current flowing between both electrode extensions 222, 222 in order to determine the electrical resistance. The electrical resistance measured under the above conditions is expressed in "$\Omega/100 \, cm^2$."

The bored thin metal film 1 (i.e. the near-field electromagnetic wave absorbing film 20) should have an electrical resistance in a range of 50 to 300 $\Omega$/100 cm$^2$. When the electrical resistance is less than 50 $\Omega$/100 cm$^2$ or more than 300 $\Omega$/100 cm$^2$, the near-field electromagnetic wave absorbing film 20 does not have sufficient electromagnetic wave absorbability. The electrical resistance of the near-field electromagnetic wave absorbing film 20 is preferably 60 to 250 $\Omega$/100 cm$^2$, more preferably 80 to 200 $\Omega$/100 cm$^2$.

(5) Protective layer

To protect the bored thin metal film 1, a protective plastic layer (not shown) is preferably formed on it. A plastic film for the protective plastic layer may be the same as the plastic film 10. The thickness of the protective plastic layer is preferably about 10 to 100 $\mu$m. To prevent detachment, a plastic film is preferably heat-laminated to the near-field electromagnetic wave absorbing film 20 as a protective layer. When the protective plastic layer is formed by a PET film, the heat lamination temperature may be 110 to 150°C.

Though a plastic film for the protective layer is usually attached to the near-field electromagnetic wave absorbing film 20 after the laser-beam-bored holes and openings have been formed in the thin metal film 11 on the plastic film 10, the laser-beam-bored holes and the openings may be formed after the protective plastic film is attached to the thin metal film 11, as long as the protective plastic film is provided with a lot of fine pores in advance. These fine pores can be formed in the protective plastic film by the method described in Japanese Patent 2063411.

[2] Electromagnetic wave absorbability of the near-field electromagnetic wave absorbing film

(1) Transmission attenuation power ratio

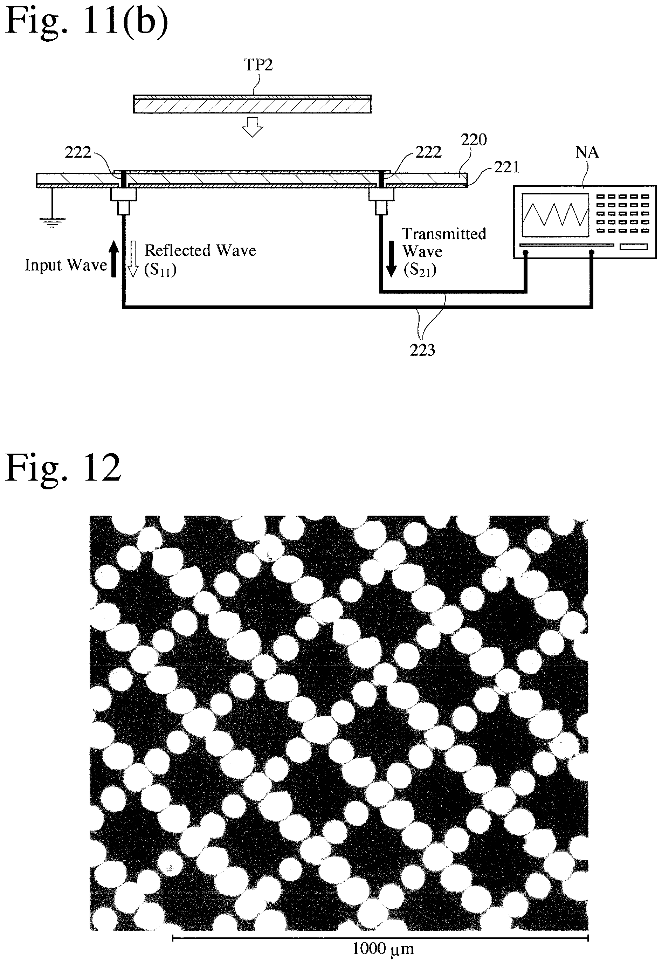

Using a system comprising a 50 $\Omega$ microstrip line MSL (64.4 mm $\times$ 4.4 mm), an insulating substrate 220 supporting the microstrip line MSL, an grounded electrode 221 attached to a lower surface of the insulating substrate 220, conductive pins 222, 222 connected to both ends of the microstrip line MSL, a network analyser NA, and coaxial cables 223, 223 connecting the network analyser NA to the conductive pins 222, 222 as shown in Figures 11(a) and 11(b), a test piece TP2 of each near-field electromagnetic wave absorbing film 20 is adhered to the microstrip line MSL in order to measure its reflected wave power $S_{11}$ and transmitted wave power $S_{21}$ relative to an input electromagnetic wave of 0.1 to 6 GHz, thereby determining its transmission attenuation power ratio Rtp by the following formula (1):

$$Rtp = -10 \times \log [10^{S21/10}/(1-10^{S11/10})] \dots (1).$$

(2) Noise absorption ratio

In the system shown in Figures 11(a) and 11(b), input power $P_{in}$ = reflected wave power $S_{11}$ + transmitted wave power $S_{21}$ + absorbed power (power loss) $P_{loss}$. Accordingly, the noise absorption ratio $P_{loss}/P_{in}$ is determined by subtracting the reflected wave power $S_{11}$ and the transmitted wave power $S_{21}$ from the input power $P_{in}$, and dividing the resultant power loss $P_{loss}$ by the input power $P_{in}$.

[3] Production method for the near-field electromagnetic wave absorbing film

Laser-beam-bored holes 12 of 200 $\mu$m or less in diameter are first formed, with intervals of 50 $\mu$m or less, on the entire surface of a thin metal film 11 formed on a plastic film 10, for example by vapour deposition. The bored thin metal film 1 is then partially provided with pluralities of openings 21 as large as giving transmission viewability. The openings 21 may be formed by irradiating laser beams. In this case, though the laser-beam-bored holes 12 and the openings 21 can be formed by one irradiation operation of laser beams, the separate formation of laser-beam-bored holes 12 and openings 21 in two steps can produce the near-field electromagnetic wave absorbing film 20 with higher efficiency. Incidentally, the openings 21 may be formed by photolithography.

The present invention will now be explained in more detail by referring to the Examples below, without any intention of restriction.

Reference Example 1 and Comparative Examples 1 and 2

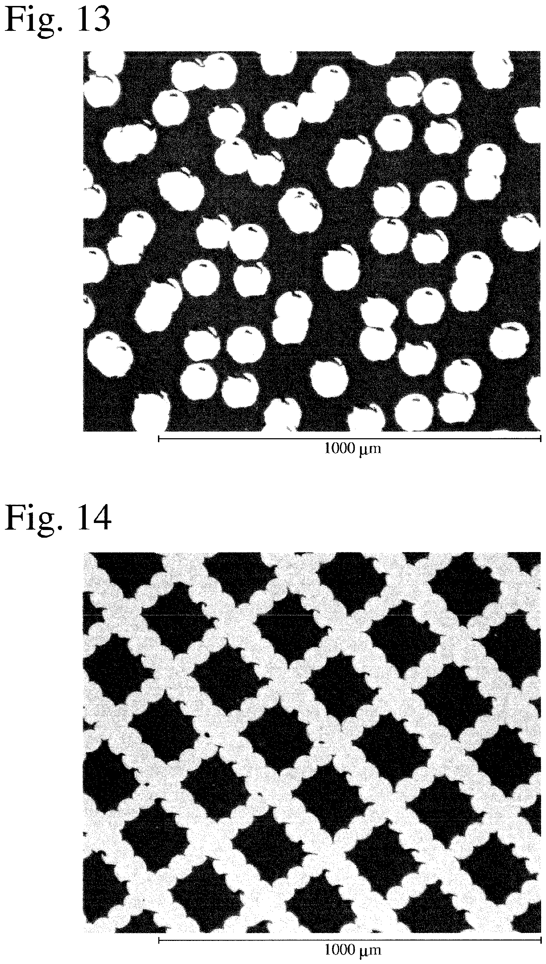

A thin Ni film 11 having a thickness of 50 nm, having been vacuum-vapour-deposited onto each PET film 10 having a thickness of 16 $\mu$m, was provided with laser-beam-bored holes 12 of 60 $\mu$m in diameter in two crossing lines by a 3-axis hybrid laser marker (MD-X1000 available from Keyence Corporation), to produce a composite film having a bored thin Ni film 1 as shown in Figures 12 to 14. The electrical resistance of a square test piece TP1 (10 cm × 10 cm) cut out of each composite film was measured by the method described in Section [1] (4). The results are shown in Table 1.

Table 1

| No. | Ref. Ex. 1 | Com. Ex. 1 | Com. Ex. 2 |
|---|---|---|---|
| Corresponding Figure | Figure 12 | Figure 13 | Figure 14 |
| Crossing Angle $\theta^{(1)}$ (°) | 90 | 90 | 90 |
| Maximum Width Wmax ($\mu$m) | 15 | 60 | 0 |
| Average Width Wav ($\mu$m) | 7 | 50 | 0 |
| Electrical Resistance ($\Omega$/100 cm$^2$) | 60 | 6 | $\infty$ |
| Note: (1) The crossing angle $\theta$ of two lines of laser-beam-bored holes. | | | |

(2) The width W of bridge-like portions.

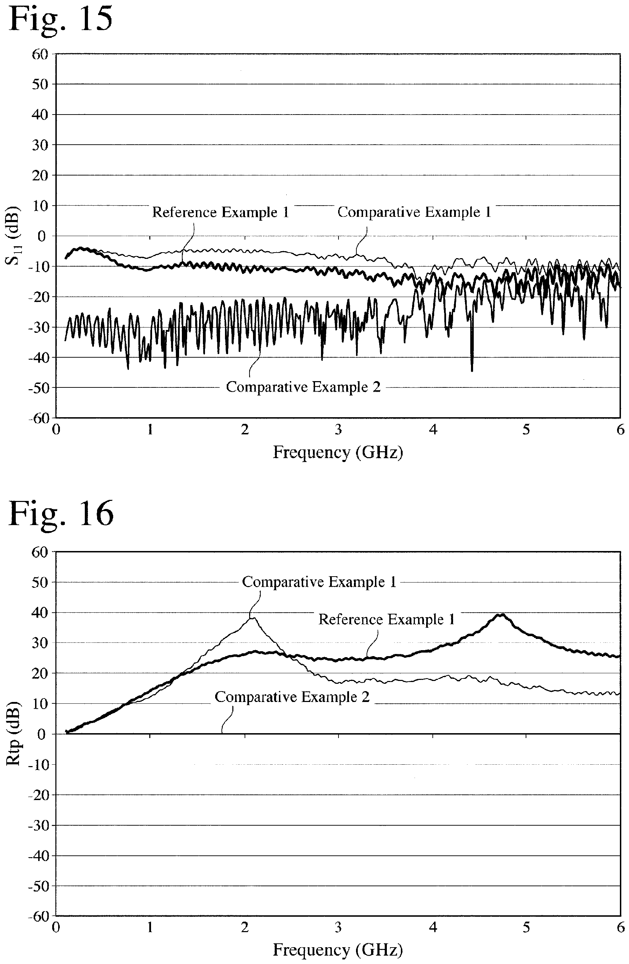

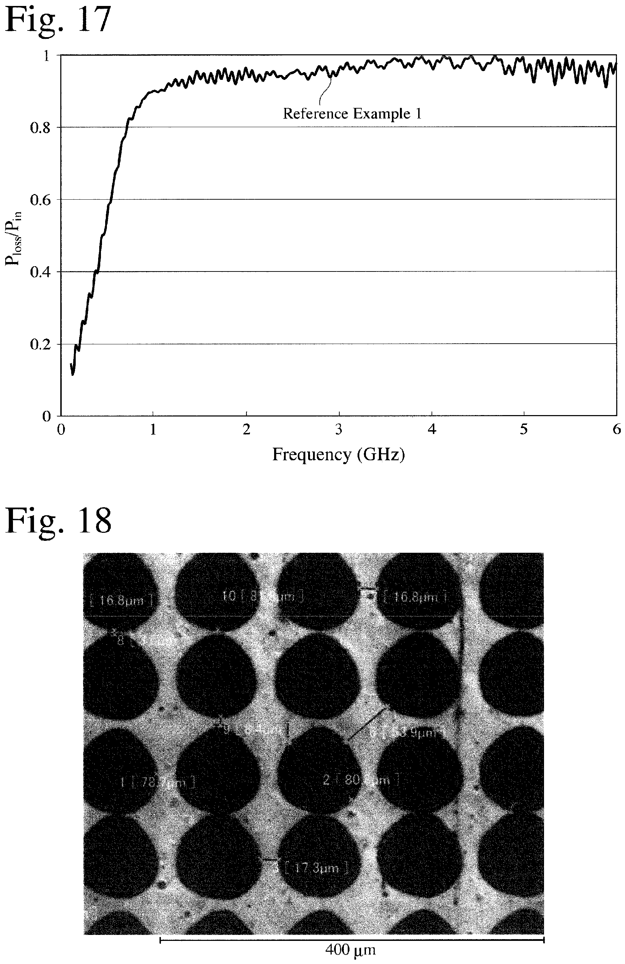

A test piece TP2 (55.2 mm × 4.7 mm) cut out of each composite film was adhered to a microstrip line MSL in the system shown in Figures 11(a) and 11(b), to measure reflected wave power $S_{11}$ and transmitted wave power $S_{21}$ relative to input power $P_{in}$ in a frequency range of 0.1 to 6 GHz by the method described in Section [2], (1) and (2), thereby determining a transmission attenuation power ratio Rtp and a noise absorption ratio $P_{loss}/P_{in}$ in a frequency range of 0.1 to 6 GHz. The $S_{11}$, transmission attenuation power ratio Rtp and noise absorption ratio $P_{loss}/P_{in}$ in a frequency range of 0.1 to 6 GHz are shown in Figures 15, 16 and 17, respectively. As is clear from Figure 15, there was a large reflected wave power $S_{11}$ in Comparative Example 1 having too few laser-beam-bored holes 12 (too low electrical resistance). Also, as is clear from Figure 16, there was a low transmission attenuation power ratio Rtp in Comparative Example 2 having excessive laser-beam-bored holes 12 (too high electrical resistance). Furthermore, as is clear from Figure 17, the composite film of Reference Example 1 had an excellent noise absorption ratio $P_{loss}/P_{in}$.

Reference Example 2

A thin Al film 11 having a thickness of 80 nm, having been vacuum-vapour-deposited onto each PET film 10 having a thickness of 16 $\mu$m, was provided with laser-beam-bored holes 12 of 80 $\mu$m in diameter in two crossing lines by a 3-axis hybrid laser marker (MD-X1000 available from Keyence Corporation), to produce a composite film having a bored thin Al film 1 shown in Figure 18. The intervals W between the laser-beam-bored holes 12 were about 20 $\mu$m. The electrical resistance of each composite film, measured by the same method as in Reference Example 1, was 60 to 80 $\Omega$/100 cm$^2$.

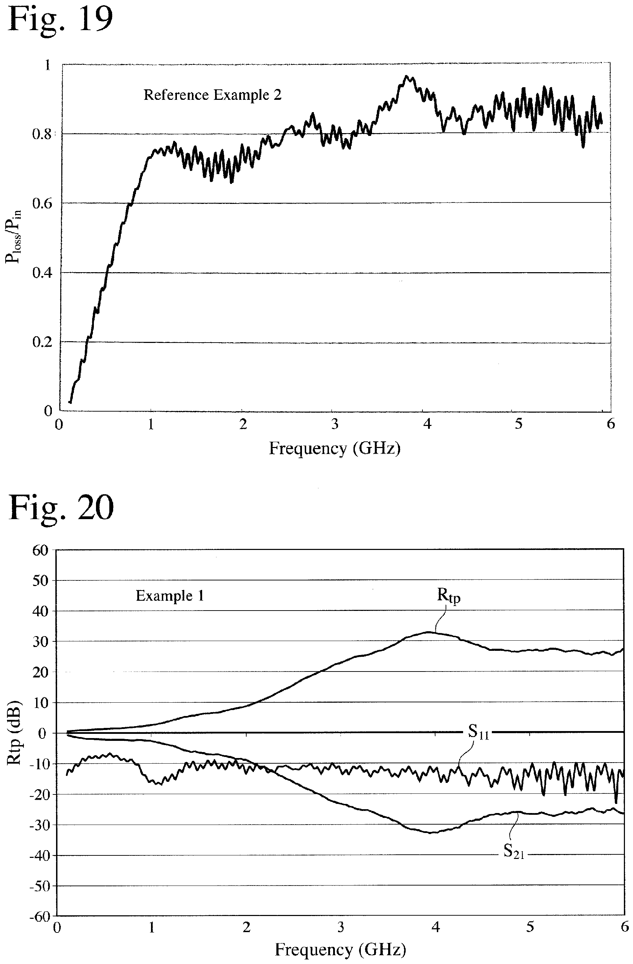

The reflected wave power $S_{11}$ and transmitted wave power $S_{21}$ of the composite film in a frequency range of 0.1 to 6 GHz were measured, in the same manner as in Reference Example 1, to determine the noise absorption ratio $P_{loss}/P_{in}$. The noise absorption ratio $P_{loss}/P_{in}$ in a frequency range of 0.1 to 6 GHz is shown in Figure 19. As is clear from Figure 19, the composite film of Reference Example 2, whose laser-beam-bored holes 12 and electrical resistance met the requirements of the present invention, had a high noise absorption ratio $P_{loss}/P_{in}$.

Examples 1 to 5

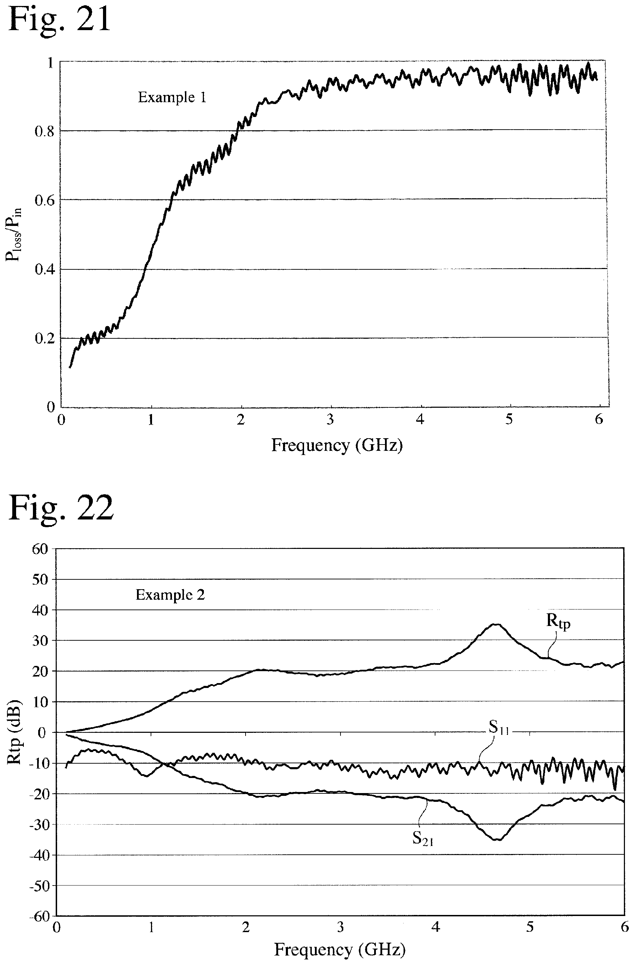

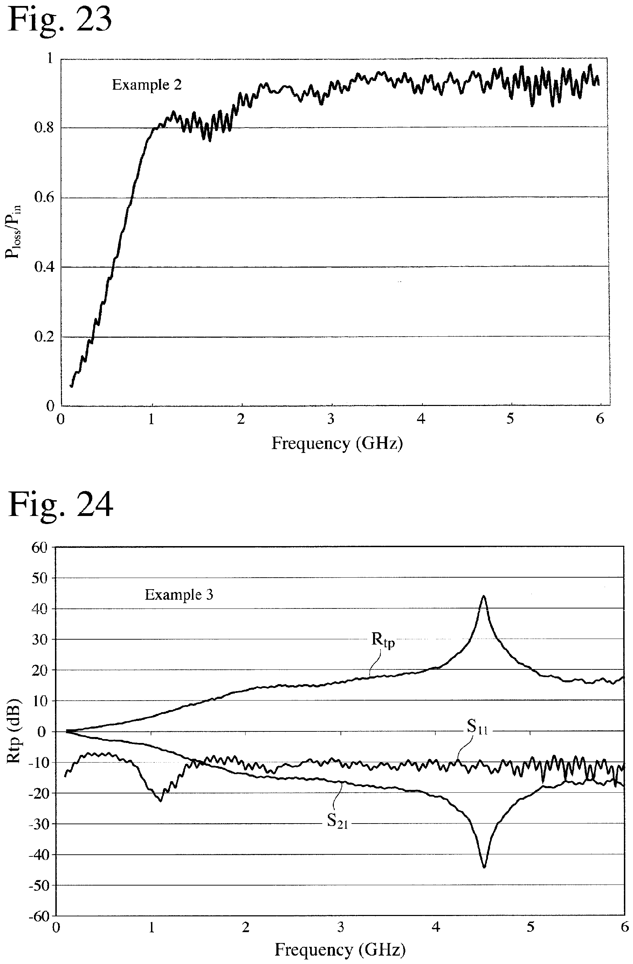

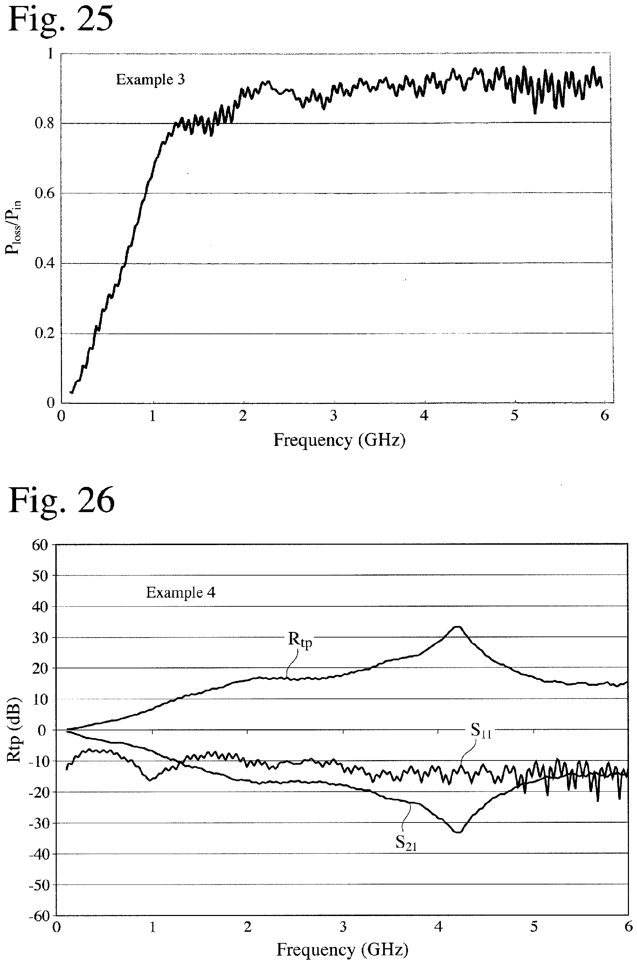

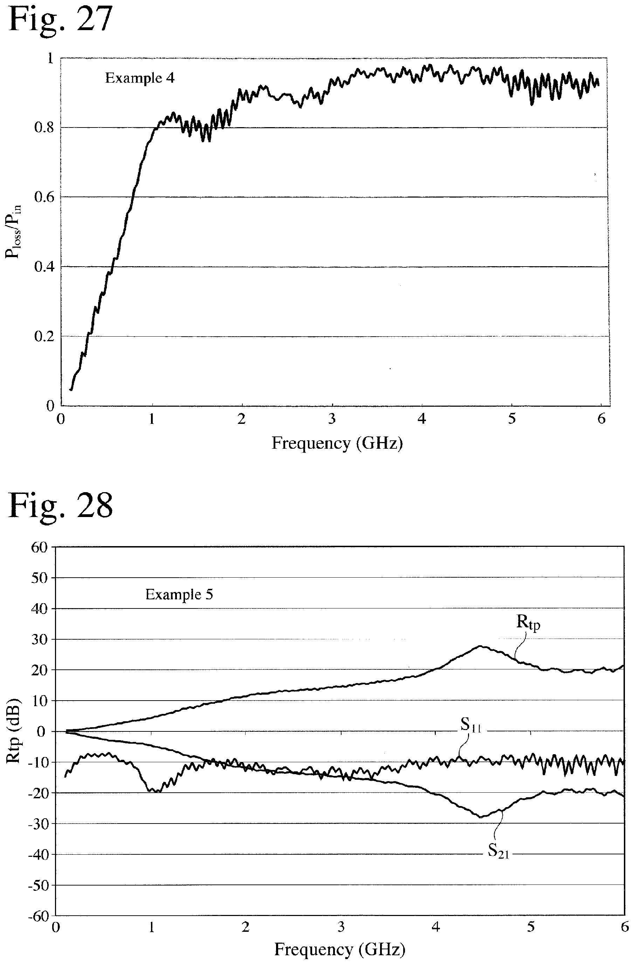

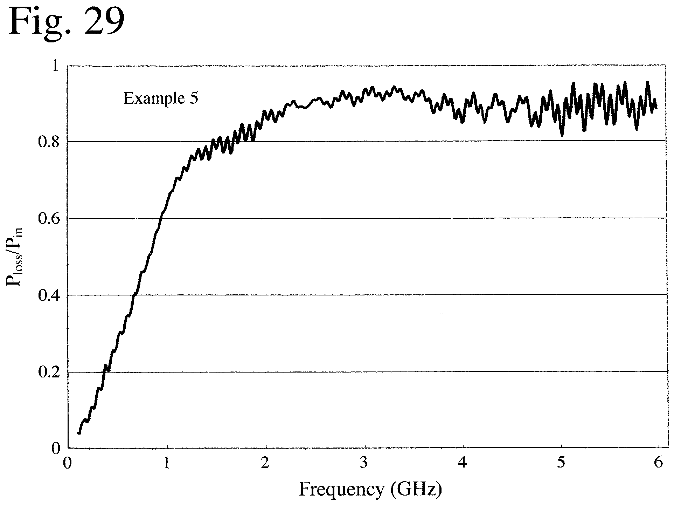

As shown in Table 2 below, openings 21 as shown in any one of Figures 3 to 6 and 9 were formed in each composite film of Reference Examples 1 and 2, to produce a near-field electromagnetic wave absorbing film. The reflected wave power $S_{11}$ and transmitted wave power $S_{21}$ of a test piece TP2 of each near-field electromagnetic wave absorbing film relative to the input power $P_{in}$ in a frequency range of 0.1 to 6 GHz were measured, in the same manner as in Reference Example 1, to determine a transmission attenuation power ratio Rtp and a noise absorption ratio $P_{loss}/P_{in}$ in a frequency range of 0.1 to 6 GHz. With respect to Examples 1 to 5, Figures 20, 22, 24, 26 and 28 show the values for $S_{11}$, $S_{21}$ and Rtp in a frequency range of 0.1 to 6 GHz, and Figures 21, 23, 25, 27 and 29 show the values for $P_{loss}/P_{in}$ in a frequency range of 0.1 to 6 GHz.

Table 2

| No. | Example 1 | Example 2 | Example 3 | Example 4 | Example 5 |
|---|---|---|---|---|---|
| Thin Metal Film Metal (Thickness: nm) | Ref. Ex. 1 Ni (50) | Ref. Ex. 2 Al (80) | Ref. Ex. 2 Al (80) | Ref. Ex. 2 Al (80) | Ref. Ex. 2 Al (80) |
| Bored Thin Metal Film | Figure 12 | Figure 18 | Figure 18 | Figure 18 | Figure 18 |
| Openings | Figure 3 | Figure 4 | Figure 5 | Figure 6 | Figure 9 |
| Area Ratio of Openings (%) | 33 | 24 | 36 | 40 | 44 |

As is clear from Figures 20 to 29, all the near-field electromagnetic wave absorbing films of Examples 1 to 5 exhibited a small reflected wave power $S_{11}$, high transmission attenuation power ratio Rtp and high noise absorption ratio $P_{loss}/P_{in}$. The near-field electromagnetic wave absorbing films of Examples 1 to 5 also had opening area ratios of 15 to 60%, providing good transmission viewability.

EFFECTS OF THE INVENTION

Because the near-field electromagnetic wave absorbing film of the present invention has large numbers of fine laser-beam-bored holes formed on the entire surface, and pluralities of openings as large as giving transmission viewability, it has excellent electromagnetic wave absorbability as well as good transmission viewability. The near-field electromagnetic wave absorbing film of the present invention having such features is suitable for electronic appliances having so-called skeleton structures whose inside can be viewed, such as mobile phones, smartphones, robots, games machines, etc.

DESCRIPTION OF REFERENCE NUMERALS

        1 bored thin metal film
        10 plastic film
        11 thin metal film
        11a remaining thin metal film portion
        12 laser-beam-bored hole
        12a, 12b line of laser-beam-bored holes
        13 main remaining portion
        14 bridge-like portion
        20 near-field electromagnetic wave absorbing film
        21 opening
        22 post-opening remaining portion
        120 electrode
        121 electrode body portion
        122 electrode extension
        130 transparent acrylic plate
        140 cylindrical weight
        220 insulating substrate
        221 earthed electrode
        222 conductive pin
        223 coaxial cable
        D diameter of laser-beam-bored hole
        W width of bridge-like portion
        T centreline distance between adjacent lines of laser-beam-bored holes
        TP1, TP2 test piece of near-field electromagnetic wave absorbing film
        MSL microstrip line
        NA network analyser

**Claims**

1. A near-field electromagnetic wave absorbing film comprising a plastic film (10) and a single-layer or multi-layer thin metal film (11) formed on one surface of said plastic film (10); **characterised in that** said thin metal film (11) has laser-beam-bored holes (12) of 200 $\mu$m or less in diameter with intervals of 50 $\mu$m or less, and pluralities of openings (21) as large as 2 to 20 mm in diameter or width, on the entire surface; and the area ratio of said openings (21) is 15 to 60 %, to give transmission viewability.

2. The near-field electromagnetic wave absorbing film according to Claim 1, wherein said laser-beam-bored holes (12) have diameters of 100 $\mu$m or less.

3. The near-field electromagnetic wave absorbing film according to Claim 1 or Claim 2, wherein said laser-beam-bored holes (12) have diameters of 20 to 100 $\mu$m.

4. The near-field electromagnetic wave absorbing film according to any one of Claims 1 to 3, wherein said laser-beam-bored holes (12) are arranged with intervals of 20 $\mu$m or less.

5. The near-field electromagnetic wave absorbing film according to any one of Claims 1 to 4, wherein said openings (21) formed in said thin metal film are arranged in at least two directions.

6. The near-field electromagnetic wave absorbing film according to any one of Claims 1 to 5, wherein the thickness of said thin metal film (11) is 10 to 300 nm.

7. The near-field electromagnetic wave absorbing film according to any one of Claims 1 to 6, wherein said thin metal film (11) is made of at least one metal selected from the group consisting of aluminium, copper, silver, tin, nickel, cobalt, chromium and their alloys.

**Patentansprüche**

1. Absorbierende Folie für elektromagnetische Nahfeldwellen umfassend eine Kunststofffolie (10) und eine dünne Einschicht- oder Mehrschicht-Metallfolie (11) gebildet auf einer Oberfläche der Kunststofffolie (10); **dadurch gekennzeichnet, dass** die dünne Metallfolie (11) Laserstrahl-gebohrte Löcher (12) mit einem Durchmesser von 200 $\mu$m oder weniger mit Intervallen von 50 $\mu$m oder weniger und Vielzahlen von Öffnungen (21) mit einem Durchmesser oder einer Breite von so groß wie 2 bis 20 mm auf der gesamten Oberfläche aufweist; und wobei das Flächenverhältnis der Öffnungen (21) 15 bis 60 % beträgt, um Transmissionssichtbarkeit zu verleihen.

2. Absorbierende Folie für elektromagnetische Nahfeldwellen gemäß Anspruch 1, wobei die Laserstrahl-gebohrten Löcher (12) Durchmesser von 100 $\mu$m oder weniger aufweisen.

3. Absorbierende Folie für elektromagnetische Nahfeldwellen gemäß Anspruch 1 oder Anspruch 2, wobei die Laserstrahl-gebohrten Löcher (12) Durchmesser von 20 bis 100 $\mu$m aufweisen.

4. Absorbierende Folie für elektromagnetische Nahfeldwellen gemäß einem der Ansprüche 1 bis 3, wobei die Laserstrahl-gebohrten Löcher (12) mit Intervallen von 20 $\mu$m oder weniger angeordnet sind.

5. Absorbierende Folie für elektromagnetische Nahfeldwellen gemäß einem der Ansprüche 1 bis 4, wobei die Öffnungen (21), die in der dünnen Metallfolie gebildet sind, in mindestens zwei Richtungen angeordnet sind.

6. Absorbierende Folie für elektromagnetische Nahfeldwellen gemäß einem der Ansprüche 1 bis 5, wobei die Dicke der dünnen Metallfolie (11) 10 bis 300 nm beträgt.

7. Absorbierende Folie für elektromagnetische Nahfeldwellen gemäß einem der Ansprüche 1 bis 6, wobei die dünne Metallfolie (11) aus mindestens einem Metall, welches aus der Gruppe ausgewählt ist, die aus Aluminium, Kupfer, Silber, Zinn, Nickel, Cobalt, Chrom und deren Legierungen besteht, hergestellt ist.

# EP 3 226 668 B1

**Revendications**

1. Film d'absorption d'ondes électromagnétique en champ proche comprenant un film plastique (10) et un film en métal mince (11) monocouche ou multicouche formé sur une surface dudit film plastique (10) ; **caractérisé en ce que** ledit film en métal mince (11) a des trous percés par faisceau laser (12) d'un diamètre de 200 μm ou moins avec des intervalles de 50 μm ou moins, et des pluralités d'ouvertures (21) d'un diamètre ou d'une largeur allant jusqu'à 2 à 20 mm, sur la surface entière ; et le rapport surfacique desdites ouvertures (21) est de 15 à 60 %, pour donner une visibilité de transmission.

2. Film d'absorption d'ondes électromagnétique en champ proche selon la revendication 1, dans lequel lesdits trous percés par faisceau laser (12) ont des diamètres de 100 μm ou moins.

3. Film d'absorption d'ondes électromagnétique en champ proche selon la revendication 1 ou la revendication 2, dans lequel lesdits trous percés par faisceau laser (12) ont des diamètres de 20 à 100 μm.

4. Film d'absorption d'ondes électromagnétique en champ proche selon l'une quelconque des revendications 1 à 3, dans lequel lesdits trous percés par faisceau laser (12) sont agencés avec des intervalles de 20 μm ou moins.

5. Film d'absorption d'ondes électromagnétique en champ proche selon l'une quelconque des revendications 1 à 4, dans lequel lesdites ouvertures (21) formées dans ledit film en métal mince sont agencées dans au moins deux directions.

6. Film d'absorption d'ondes électromagnétique en champ proche selon l'une quelconque des revendications 1 à 5, dans lequel l'épaisseur dudit film en métal mince (11) est de 10 à 300 nm.

7. Film d'absorption d'ondes électromagnétique en champ proche selon l'une quelconque des revendications 1 à 6, dans lequel ledit film en métal mince (11) est constitué d'au moins un métal choisi dans le groupe constitué par l'aluminium, le cuivre, l'argent, l'étain, le nickel, le cobalt, le chrome et leurs alliages.

## Fig. 1(a)

## Fig. 1(b)

# Fig. 1(c)

# Fig. 2

# Fig. 3

# Fig. 4

# Fig. 5

Fig. 6

Fig. 7

# Fig. 8

# Fig. 9

# Fig. 10(a)

# Fig. 10(b)

# Fig. 10(c)

# Fig. 11(a)

# Fig. 11(b)

# Fig. 12

1000 μm

Fig. 13

1000 μm

Fig. 14

1000 μm

## Fig. 15

## Fig. 16

## Fig. 17

Reference Example 1

## Fig. 18

400 μm

## Fig. 19

Reference Example 2

## Fig. 20

Example 1

$R_{tp}$

$S_{11}$

$S_{21}$

## Fig. 21

## Fig. 22

## Fig. 23

## Fig. 24

## Fig. 25

## Fig. 26

## Fig. 27

## Fig. 28

# Fig. 29

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 9148782 A
- WO 2010093027 A
- EP 1993338 A1
- WO 2014148589 A1
- JP 2063411 A